(19)

Europäisches Patentamt

European Patent Office

Office européen des brevets

(11) **EP 4 191 338 A1**

(12) **EUROPEAN PATENT APPLICATION**

(43) Date of publication:
**07.06.2023 Bulletin 2023/23**

(21) Application number: **21212240.2**

(22) Date of filing: **03.12.2021**

(51) International Patent Classification (IPC):
***G03F 7/20*** (2006.01)    ***G06N 20/00*** (2019.01)

(52) Cooperative Patent Classification (CPC):
**G03F 7/70483; G03F 7/70491; G03F 7/705;**
**G03F 7/70616; G03F 7/70633; G06N 20/00**

| | |
|---|---|
| (84) Designated Contracting States:<br>**AL AT BE BG CH CY CZ DE DK EE ES FI FR GB**<br>**GR HR HU IE IS IT LI LT LU LV MC MK MT NL NO**<br>**PL PT RO RS SE SI SK SM TR**<br>Designated Extension States:<br>**BA ME**<br>Designated Validation States:<br>**KH MA MD TN**<br><br>(71) Applicant: **ASML Netherlands B.V.**<br>**5500 AH Veldhoven (NL)** | (72) Inventors:<br>• **BOTTEGAL, Giulio**<br>  **5500 AH Veldhoven (NL)**<br>• **SANGUINETTI, Gonzalo, Roberto**<br>  **5500 AH Veldhoven (NL)**<br><br>(74) Representative: **ASML Netherlands B.V.**<br>**Corporate Intellectual Property**<br>**P.O. Box 324**<br>**5500 AH Veldhoven (NL)** |

(54) **METROLOGY CALIBRATION METHOD**

(57)     Disclosed is a method of calibrating a model for inferring a value for a parameter of interest from a measurement signal comprising obtaining a first set of metrology signals, corresponding known reference values for the parameter of interest; and at least first and second constraining sets of metrology signals relating to the same application as said first set of metrology signals. The first set of metrology signals and corresponding reference data is used to train at least one model to infer a value for the parameter of interest from said first set of metrology signals subject to a constraint that a difference between first inferred values for the parameter of interest using the model on at least the first constraining set of metrology signals and second inferred values for the parameter of interest using the model on the second constraining set of metrology signals is below a threshold value.

Fig. 3

**Description**

BACKGROUND

Field of the Invention

The present invention relates to a metrology apparatus and methods usable, for example, to perform metrology in the manufacture of devices by lithographic techniques. The invention further relates to such methods for monitoring a parameter of interest such as overlay in a lithographic process.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

To infer a value for a parameter of interest, such as overlay, from a metrology signal, a model (also known as a recipe) may be constructed and trained using a data-driven approach such that the model learns how to associate the parameter of interest to the metrology signals. This learning may be based on calibration data from reference or calibration wafers, for which corresponding reference values of the parameter(s) of interest are known.

It would be desirable to improve on such model calibration methods.

SUMMARY OF THE INVENTION

The invention in a first aspect provides a method of calibrating a model for inferring a value for a parameter of interest from a measurement signal; the method comprising: obtaining a first set of metrology signals, and corresponding reference data comprising respective known reference values for the parameter of interest for said first set of metrology signals; obtaining at least a first constraining set of metrology signals and a second constraining set of metrology signals, said first constraining set of metrology signals and second constraining set of metrology signals relating to the same application as said first set of metrology signals; and training, using said first set of metrology signals and corresponding reference data, at least one model to infer a value for the parameter of interest from said first set of metrology signals subject to a constraint that a difference between first inferred values for the parameter of interest using the model on at least the first constraining set of metrology signals and second inferred values for the parameter of interest using the model on the second constraining set of metrology signals is below a threshold value.

The invention yet further provides a computer program product comprising machine-readable instructions for causing a processor to perform the method of the first aspect, and associated metrology apparatus and lithographic system.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying schematic drawings in which corresponding reference symbols indicate corresponding parts, and in which:

> Figure 1 depicts a lithographic apparatus;
> Figure 2 depicts a lithographic cell or cluster in which an inspection apparatus according to the present invention may be used; and
> Figure 3 illustrates schematically an inspection apparatus adapted to perform angle-resolved scatterometry and dark-field imaging inspection methods;

DETAILED DESCRIPTION OF EXEMPLARY EMBODIMENTS

Before describing embodiments of the invention in detail, it is instructive to present an example environment in which embodiments of the present invention may be implemented.

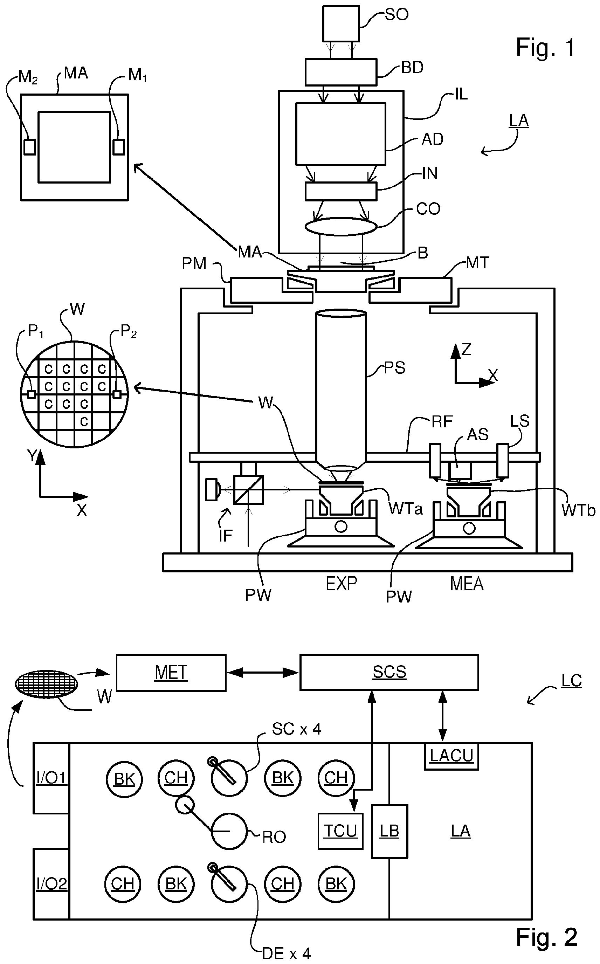

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

Patterning device (e.g., reticle/mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties or parameters of interest such as overlay between subsequent layers, line thicknesses, critical dimensions (CD), etc. Accordingly a manufacturing facility in which lithocell LC is located also includes metrology system MET which receives some or all of the substrates W that have been processed in the lithocell.

Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

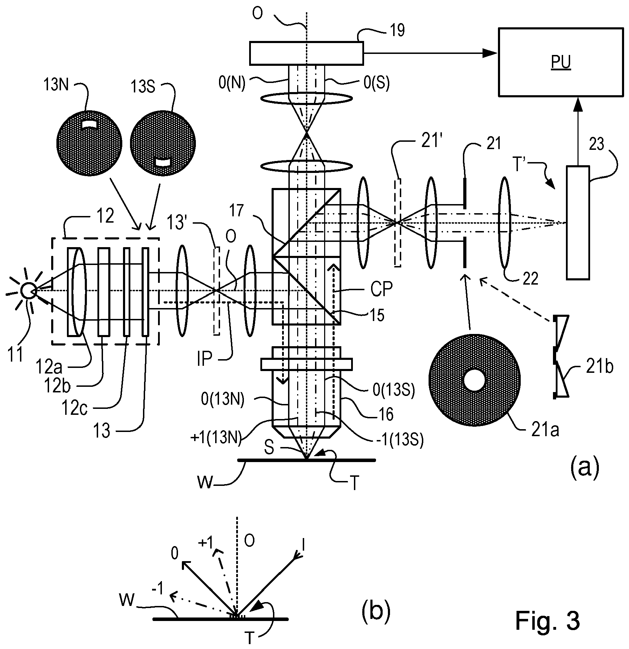

A metrology apparatus suitable for use in embodiments of the invention is shown in Figure 3(a). Note that this is only one example of a suitable metrology apparatus. An alternative suitable metrology apparatus may use EUV radiation such as, for example, that disclosed in WO2017/186483A1. Many other types of metrology apparatuses are known and may equally be used to implement the concepts disclosed herein. A target structure T and diffracted rays of measurement radiation used to illuminate the target structure are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 3(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

Position errors may occur due to an overlay error (often referred to as "overlay"). The overlay is the error in placing a first feature during a first exposure relative to a second feature during a second exposure. The lithographic apparatus minimizes overlay by aligning each substrate accurately to a reference prior to patterning, e.g., by measuring positions of alignment marks on the substrate using an alignment sensor; and by using feedback corrections for the exposure process; e.g., based on measuring overlay on metrology targets post-exposure using a suitable metrology tool.

To improve the accuracy of a metrology tool, it is known to calibrate or configure the metrology tool for a particular stack or product being manufactured such that, when so configured, the tool can be used to measure a parameter of interest from such a stack. This may be achieved by constructing a model which can infer values for the parameter of interest from metrology signals acquired with the metrology tool. To create such a model, a data-driven approach may be used to train the model to infer the parameter of interest from the metrology signals, e.g., using labeled training data such as from wafers with known reference data or reference values for the parameter of interest.

Such an approach may comprise measuring calibration targets with a known parameter of interest value (e.g., a known overlay or focus value). Using an overlay example, such calibration targets may be formed with a deliberate or imposed known bias and/or may have the reference overlay values measured using another more accurate metrology technique such as a scanning electron microscope (SEM), which is too slow for most high volume manufacturing (HVM) metrology applications. A model (e.g., a machine learning model or physics-based model) can then be trained to map measured calibration signals from the calibration targets to the known reference values.

The calibration measurements may be performed from a single measurement setting, which reflect the measurement setting that may be used in normal operation mode. Alternatively, the calibration measurements may be performed for a number of different measurement settings, e.g., one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc.. Models may be trained for each measurement setting, and the combination of trained model and measurement setting (a "measurement recipe") which provides the best overall performance may be chosen to be used for a particular application (e.g., to measure a particular stack). One of the criteria to select a measurement recipe may, for example, be a sensitivity of one of the measurement parameters to processing variations.

The metrology signals may comprise or be derived from, for example, either pupil images (e.g., an angularly resolved pattern imaged at a pupil plane or a conjugate thereof such as by detector 19 in the pupil branch of metrology tool of Figure 3(a)) or field images (e.g., imaged at an image/field plane or a conjugate thereof such as by detector 23 in the imaging branch of metrology tool of Figure 3(a)) associated with measurements performed on suitable targets. In either case, the metrology signals may comprise intensity signals, phase signals or a combination of both.

There is a lot of information which is available during the model setup that is presently unused. It is therefore proposed to exploit this additional information to improve the quality of the trained recipe. For example, the concepts disclosed herein may use one or more Key Performance Indicators (KPIs) which are typically monitored to assess the quality of a metrology system.

An example of smart use of additional information to target a specific KPI may be referred to as the Cross-System Training (CST) method. This method relies on measuring one or more wafers with two different metrology tools (e.g. of the same type). By comparing (per wafer target) the signals acquired in the two tools, it can train models with low tool-to-tool parameter mismatch. In this case, the specific aim of the method is to improve tool-to-tool overlay matching. A clear limitation of CST is that it requires a number of wafers to be measured on two tools, and that it targets improvement of only tool-to-tool matching with respect to current baseline recipe creation methodology.

An improved calibration method to calibrate or train a model for deriving a parameter of interest from a metrology signal is proposed. The improved method may comprise training the model with one or more additional sets of metrology signals (at least a first constraining set of metrology signals), in addition to a first set of metrology signals (a main training set of metrology signals) conventionally used to train the model, where all the sets of metrology signals relating to the same application (e.g., the same stack), measured on the same metrology tool. The model may be trained to minimize the difference between values for a parameter of interest inferred using the model from the first set of metrology signals and their respective known reference values, subject to the constraint that a difference between inferred values for the parameter of interest using the same model on at least a first constraining set of metrology signals and a second constraining set of metrology signals is below a threshold value; and where all the sets of metrology signals relate to a common application or stack.

The first and second constraining sets of metrology signals may comprise two additional sets of metrology signals (i.e., additional to the first set of metrology signals), or else the first set of metrology signals may be additionally used as one of the first and second constraining sets of metrology signals.

To train a model for a metrology system in a calibration phase, a function is learnt that can map metrology signals $s_i$, acquired at a given target location $i$, to a parameter of interest $p_i$, of which a reference value is known. This learning task can be formulated as:

$$\min_{f \in D} \sum_{targets\ i} \left( p_i - f(s_i) \right)^2 + R(f)$$

where $f$ is the object of the learning task (the model), i.e., a function that maps the metrology signals into the parameter of interest, and $R(f)$ is a (optional) regularization term that helps balance prior information on the structure of $f$ and adherence to data.

The proposed method applies an additional constraint based on a comparison of first constraining set of metrology signals and a second constraining set of metrology signals $s_j^1$ and $s_j^2$ acquired at the target locations $j = 1, ..., N_t$. The target locations indicated by index $j$ may describe the same actual targets over each set of metrology signals, or different actual targets in neighboring locations or from the same region (e.g., the same field) over each set of metrology signals.

In a specific embodiment, the calibration may be performed via the learning task:

$$\min_{f \in D} \sum_{targets\ i} \left( p_i - f(s_i) \right)^2 + R(f)$$

subject to:

$$\frac{1}{N_t} \sum_{targets\ j} \left( f(s_j^1) - f(s_j^2) \right)^2 \leq \varepsilon$$

where $\varepsilon$ is a threshold parameter specifying an allowed tolerance in the mismatch between the parameter values extracted from the two constraining sets of metrology signals.

It should be appreciated that this is only an example of a learning task. For example, the regularization term is optional. Furthermore, the minimization of either the main learning task (between parameter of interest value and first set of measurement signals) and/or the constraint (between the two constraining sets of metrology signals) does not necessarily need to be a least-squares minimization as shown (e.g., it may be based on a norm other than an L2 norm).

The two constraining sets of metrology signals may be different in the environmental conditions (e.g., measurement settings used and/or target types measured) under which they are acquired, or possibly only the time at which they are acquired, provided that they are expected to comprise the same stack information and therefore relate to the same value (or magnitude) for the parameter of interest. The constraint enforces that the learned function or model $f$ is able to extract the same parameter value (within the margin of error defined by the threshold parameter) from the two constraining signals.

The formulation of the learning task allows for flexibility in creating models with desired properties (i.e. improved targeted KPIs). Some examples will now be provided, which may be targeted at one or more specific KPIs.

Tool-induced asymmetry based KPI

The intensity profile in the diffraction pattern may be affected by properties of the measurement tool. In particular, an issue referred to herein as "tool-induced asymmetry" can have an undesirable impact on a measurement. Tool-induced asymmetry may describe tool properties which result in a difference between the diffraction pattern in the +X direction compared to the diffraction pattern in the -X direction. One known way to address this issue, is to perform a wafer rotation (WR) measurement comprising two measurements on each single target: a first acquisition with the target in a first target or nominal target orientation, and a second acquisition with the target in a second target or rotated target orientation, the rotation being 180 degrees along its normal with respect to the nominal configuration. A tool-asymmetry-corrected (TAC) image may then be constructed as an averaged measurement comprising an average of the first and second acquisitions. Such a method is described, for example, in US2008/0239318 which is incorporated herein by reference.

To further reduce such a tool-induced asymmetry error, the methods described herein may be used to constrain the model to give the same parameter estimates (within the threshold parameter) when used on the first acquisitions and the second acquisitions. This may be achieved by setting the first constraining set of metrology signals $s_j^1$ to be the first acquisitions (those measured at 0 degrees) and the second constraining set of metrology signals $s_j^2$ to be the second acquisitions (those measured at 180 degrees). This forces the learned model $f$ to avoid using the part of the signal that is generated by sensor imperfection, as this error manifests itself differently when the acquisition angle changes, whereas the parameter signal does not. In this embodiment, the first and second constraining sets of metrology signals $s_j^1$, $s_j^2$ may relate to the same targets $j$. The first set of metrology signals $s_i$ may comprise the TAC averaged signals or either of the first and second acquisition signals (i.e., the same sets as either of the constraining sets of metrology signals). The first set of metrology signals may relate to the same targets as the first and second constraining sets of metrology signals (i.e., targets $i$ and $j$ may describe the same targets).

Tool Measurement Uncertainty (TMU)

TMU is a KPI which is sometimes used in metrology to compare two types of metrology techniques when measuring the same targets on the same metrology tool; e.g., a first measurement technique which is faster but at a cost of accuracy (or certainty) and a second measurement technique which is slower but more accurate. The TMU KPI may quantify the error in a parameter of interest inference resultant from using the first technique compared to using the second technique. In a specific example, the second technique may be the standard WR mode described in the previous section and the first technique may be that referred to as the Asymmetry Correction (AC) algorithm. The AC algorithm is a technique which increases throughput (by reducing the number of double measurements for each target) at the cost of accuracy versus a WR measurement. The AC algorithm, also described in US2021/0255552 which is incorporated herein by reference, uses only a reduced number of measurements of targets in WR mode to build a model that predicts how to correct sensor-induced asymmetries in other targets, which are measured at a single orientation (e.g., 0 degrees) only.

The proposed method may be used to decrease this TMU error in an AC measurement. This may be achieved by setting the first constraining set of metrology signals $s_j^1$ to be those obtained according to the WR measurement mode and the second constraining set of metrology signals $s_j^2$ to be those measured using the AC measurement mode. In this embodiment, the first and second constraining sets of metrology signals $s_j^1$, $s_j^2$ may relate to the same targets $j$. The first set of metrology signals $s_i$ may comprise those measured using the AC measurement mode (i.e., the same set as the second constraining set of metrology signals). The first set of metrology signals may relate to the same targets as the first and second constraining sets of metrology signals (i.e., targets $i$ and $j$ may describe the same targets).

Self-reference targets to in-die targets

A present metrology method comprises in-die metrology (IDM), which is based on measurement of in-die targets on a spatial scale similar to the actual product structures for which they act as proxy (in fact, IDM metrology may be performed directly on the product structure if it is sufficiently regularized, and the term "target" used herein may refer to actual product structure when being used for metrology). The in-die targets are designed to be representative (e.g., to mimic) the exposure behavior, or more generally, the full patterning behavior of the product structure which they represent.

As with many of the other embodiments described herein, the in-die targets may be measured using the first measurement branch of the tool of Figure 3, or other suitable angle-resolved metrology apparatus to obtain a measurement pupil. A measurement pupil may comprise an "image" or acquisition of the pupil plane, i.e., an angle resolved spectrum or Fourier representation of the scattered radiation from the in-die target.

To train the model, self-referencing targets or reference targets may be provided on a reticle which also comprises the in-die targets. These in-die and reference targets can then be exposed, processed (e.g., etched etc.) on a wafer and measured. These reference targets may, for example, be located at the periphery of the field (e.g., in a scribe lane). The reference targets typically comprise a target array comprising multiple targets with different biases. The biases may average (or sum to) zero over the array such that a measurement averaged over the array should represent the on-product overlay. Measurement signals acquired on each reference target are labeled with the overlay bias (across the exposed layers) for training purposes. These training label biases/overlay values are known with good accuracy, since reticle writing error is small. The model then learns to associate a specific reference target measurement signal with its respective reference target overlay bias value or label.

The training may be repeated for different acquisition settings (e.g., wavelengths/polarizations etc. of the measurement radiation) and/or other settings varied and/or for different training wafers, e.g., to allow for processing variations between nominally identical targets. The output of such training may comprise multiple, e.g., in the order of hundreds (for example between 100 and 500), candidate measurement recipes, wherein a measurement recipe may be a combination of a trained model and an acquisition setting. For example, during training the acquisition setting may be a free parameter such that each acquisition setting has a corresponding model, such that a measurement recipe comprises the combination of these. There will be different weight matrices within the model for each recipe.

The in-die targets may be formed without any intentional overlay bias and therefore have no explicit label (i.e. they are labeled zero). A matching step is then performed to determine a matching metric or matching indicator (matching KPI) which quantifies how well matched the in-die target response is to the self-reference target response. This matching is typically performed by inferring an overlay value from the reference targets using a candidate metrology recipe and comparing this to an inferred overlay value from an in-die target using the same candidate metrology recipe. The closer the inferred values are, the better matched the measurement recipe is (e.g., the matching KPI may be based on the difference between the values). More specifically, present methods may compare an average of the inferred overlay values from the reference target array (over which the biases will average/sum to zero) and an overlay value inferred from a single in-die target (for example the in-die target nearest the reference cluster). To improve the effectiveness of this matching of in-die targets to reference targets, the proposed method may be applied. This may be achieved by setting the first constraining set of metrology signals $s_j^1$ to be the reference target acquisitions and the second constraining set of metrology signals $s_j^2$ to be the in-die target acquisitions, or a subset thereof (e.g., a nearest one or more in-die target acquisition for each reference target array. In this embodiment, the first and second constraining sets of metrology signals $s_j^1$, $s_j^2$ may relate to different actual targets, where the index $j$ describes a region (e.g., $j$ refers to a particular reference target cluster and one or more nearest in-die target(s)). The first set of metrology signals $s_i$ may comprise the full set of the in-die target acquisitions (i.e., index $j$ may be a subset of index $i$).

Reciprocity

A theoretical property of optical systems that can be used to improve the accuracy of the calibrated model or recipes is that the signal acquired at a certain polarization should be exactly the opposite of the signal acquired at the opposite polarization. To exploit this property, the concepts disclosed herein may be used with the first constraining set of metrology signals $s_j^1$ to be target acquisitions using a first polarization (e.g., horizontal) and the second constraining set of metrology signals $s_j^2$ to be target acquisitions using a second polarization, opposite the first polarization (e.g., vertical). In such an embodiment, the second set of metrology signals will have reversed sign, and therefore the constraint above may sum the sets to compensate;

$$\text{e.g.:} \quad \frac{1}{N_t} \sum_{targets\ j} \left( f\left(s_j^1\right) + f\left(s_j^2\right) \right)^2 \leq \varepsilon$$

The first set of metrology signals $s_i$ may comprise those measured using either polarization, or a combination of both. The first set of metrology signals may relate to the same targets as the first and second constraining sets of metrology signals (i.e., targets $i$ and $j$ may describe the same targets).

Reproducibility (repro)

Repro is an important KPI in metrology, as it evaluates the error contribution due to stochastic effects that happen every time a new measurement is performed. The concepts disclosed herein may be used to improve repro for a model or recipe. This may be achieved by setting the first constraining set of metrology signals $s_j^1$ to be first acquisitions of targets at a first time and the second constraining set of metrology signals $s_j^2$ to be the second acquisitions of the same targets (and under the same conditions) at a second time. By minimizing the difference in the parameter inference between these two acquisitions, repro can be reduced, as the learned model $f$ can better understand what parts of the acquired signal are due to noise. In this embodiment, the first and second constraining sets of metrology signals $s_j^1$, $s_j^2$ relate to the same targets $j$. The first set of metrology signals $s_i$ may comprise either of the first or second acquisition signals, or signals acquired at another time.

In other embodiments, the first and second constraining sets of metrology signals $s_j^1$, $s_j^2$ may relate to sets of signals obtained with respective different wavelengths and/or with respective different angles of incidence (measurement angle of the measurement beam with respect to the target). In fact any environmental conditions which affect the measurement signals (including simply the time of acquisition as has been described) may be varied between the sets.

Further embodiments of the method, metrology device and lithographic apparatus are disclosed in the subsequent list of numbered clauses:

1. A method of calibrating a model for inferring a value for a parameter of interest from a measurement signal; the method comprising:

obtaining a first set of metrology signals, and reference data comprising respective known reference values for the parameter of interest, the reference data corresponding to said first set of metrology signals;
obtaining at least a first constraining set of metrology signals and a second constraining set of metrology signals, said first constraining set of metrology signals and second constraining set of metrology signals relating to the same application as said first set of metrology signals; and
training, using said first set of metrology signals and corresponding reference data, at least one model to infer a value for the parameter of interest from said first set of metrology signals subject to a constraint that a difference between first inferred values for the parameter of interest using the model on at least the first constraining set of metrology signals and second inferred values for the parameter of interest using the model on the second constraining set of metrology signals is below a threshold value.

2. A method as defined in clause 1, wherein said first set of metrology signals, said first constraining set of metrology signals and said second constraining set of metrology signals are all measured on a single metrology tool.

3. A method as defined in clause 1 or 2, wherein at least said first constraining set of metrology signals and said second constraining set of metrology signals are each obtained using at least one different environmental condition and/or at a different time.

4. A method as defined in clause 1, 2 or 3, wherein said first set of metrology signals, said first constraining set of metrology signals and said second constraining set of metrology signals are each different sets of metrology signals.

5. A method as defined in clause 4, wherein said first set of metrology signals, said first constraining set of metrology signals and said second constraining set of metrology signals are each obtained using at least one different environmental condition and/or at a different time.

6. A method as defined in clause 1, 2 or 3, wherein said first set of metrology signals and one of said first constraining set of metrology signals and said second constraining set of metrology signals comprise a common set of metrology signals.

7. A method as defined in any preceding clause, wherein said first constraining set of metrology signals and said second constraining set of metrology signals are each measured on the same set of targets.

8. A method as defined in clause 7, wherein said first set of metrology signals are measured on said same set of targets.

9. A method as defined in clause 7 or 8, wherein said first constraining set of metrology signals relate to measurements of said set of targets at a first substrate orientation and said second constraining set of metrology signals relate to measurements of said set of targets at a second substrate orientation.

10. A method as defined in clause 9, wherein said first set of metrology signals comprises a combination of said measurements of said set of targets at the first substrate orientation and said measurements of said set of targets at the second substrate orientation.

11. A method as defined in clause 7 or 8, wherein said first constraining set of metrology signals relate to measurements of said set of targets using a first measurement technique and said second constraining set of metrology signals relate to measurements of said set of targets using a second measurement technique.

12. A method as defined in clause 11, wherein said first measurement technique comprises performing measurements at a first orientation and a second orientation to correct for metrology tool asymmetry and said second measurement technique comprises an application of an asymmetry correction algorithm to correct for metrology tool asymmetry.

13. A method as defined in clause 7 or 8, wherein said first constraining set of metrology signals relate to measurements of said set of targets using radiation having a first polarization state and said second constraining set of metrology signals relate to measurements of said set of targets using radiation having a second polarization state, opposite to said first polarization state.

14. A method as defined in clause 7 or 8, wherein said first constraining set of metrology signals relate to measurements of said set of targets at a first time and said second constraining set of metrology signals relate to measurements of said set of targets at a second time.

15. A method as defined in any of clauses 1 to 6, wherein said first constraining set of metrology signals relate to measurements of a first set of targets or a subset thereof and said second constraining set of metrology signals relate to measurements of a second set of targets, each of said second set of targets corresponding to one or more of said first set of targets or a subset thereof.

16. A method as defined in clause 15, wherein said first set of targets comprise in-die targets and said second set of targets comprise reference targets.

17. A method as defined in clause 16, wherein said reference targets are grouped into a plurality of target arrays, each target array being located within a scribe lane.

18. A method as defined in clause 15, 16 or 17, wherein said first set of metrology signals relate to measurements of the first set of targets, and said reference data relates to said second set of targets.

19. A method as defined in any preceding clause, wherein said difference is determined for respective pairs of metrology signals, each pair comprising one metrology signal of said first constraining set of metrology signals and one metrology signal of said second constraining set of metrology signals.

20. A method as defined in any preceding clause, wherein said training step trains the model to minimize a difference between values for the parameter of interest inferred using the model from the first set of metrology signals and their respective known reference values.

21. A method as defined in any preceding clause, wherein said same application comprises the same product structure(s) and/or stack.

22. A method as defined in any preceding clause, comprising performing metrology on one or more calibration substrates to obtain said first set of metrology signals, said first constraining set of metrology signals and said second constraining set of metrology signals.

23. A method as defined in any preceding clause, comprising subsequently using said trained model to infer a value for the parameter of interest from a metrology signal obtained from a production substrate.

24. A computer program comprising processor readable instructions which, when run on suitable processor controlled apparatus, cause the processor controlled apparatus to perform the method of any of clauses 1 to 23.

25. A computer program carrier comprising the computer program of clause 24.

26. A processing apparatus comprising:

    a processor; and
    a computer program carrier comprising the computer program of clause 24.

27. A metrology apparatus comprising the processing apparatus of clause 26.

In summary, the concepts disclosed herein relate to a general methodology which may be applied to model training or recipe creation to improve inference performance; e.g., in terms of one or more KPIs. Such a method may make use of different measurements settings which are often already presently used to measure calibration wafers when training models. By suitably combining the signals relating to the measurement settings, improved models/recipes can be obtained for a metrology application. In particular, only measurements from a single metrology tool are required.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The term target should not be construed to mean only dedicated targets formed for the specific purpose of metrology. The term target should be understood to encompass other structures, including product structures, which have properties suitable for metrology applications.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method of calibrating a model for inferring a value for a parameter of interest from a measurement signal; the method comprising:

    obtaining a first set of metrology signals, and reference data comprising respective known reference values for the parameter of interest, the reference data corresponding to said first set of metrology signals;
    obtaining at least a first constraining set of metrology signals and a second constraining set of metrology signals, said first constraining set of metrology signals and second constraining set of metrology signals relating to the same application as said first set of metrology signals; and
    training, using said first set of metrology signals and corresponding reference data, at least one model to infer a value for the parameter of interest from said first set of metrology signals subject to a constraint that a difference between first inferred values for the parameter of interest using the model on at least the first constraining set of metrology signals and second inferred values for the parameter of interest using the model on the second constraining set of metrology signals is below a threshold value.

2. A method as claimed in claim 1, wherein said first set of metrology signals, said first constraining set of metrology signals and said second constraining set of metrology signals are all measured on a single metrology tool.

3. A method as claimed in claim 1 or 2, wherein at least said first constraining set of metrology signals and said second constraining set of metrology signals are each obtained using at least one different environmental condition and/or at a different time.

4. A method as claimed in claim 1, 2 or 3, wherein said first set of metrology signals, said first constraining set of metrology signals and said second constraining set of metrology signals are each different sets of metrology signals.

5. A method as claimed in claim 4, wherein said first set of metrology signals, said first constraining set of metrology signals and said second constraining set of metrology signals are each obtained using at least one different environmental condition and/or at a different time.

6. A method as claimed in any preceding claim, wherein said first constraining set of metrology signals and said second constraining set of metrology signals are each measured on the same set of targets.

7. A method as claimed in claim 6, wherein said first set of metrology signals are measured on said same set of targets.

8. A method as claimed in claim 6 or 7, wherein said first constraining set of metrology signals relate to measurements of said set of targets at a first substrate orientation and said second constraining set of metrology signals relate to measurements of said set of targets at a second substrate orientation.

9. A method as claimed in claim 6 or 7, wherein said first constraining set of metrology signals relate to measurements of said set of targets at a first time and said second constraining set of metrology signals relate to measurements of said set of targets at a second time.

10. A method as claimed in any of claims 1 to 5, wherein said first constraining set of metrology signals relate to measurements of a first set of targets or a subset thereof and said second constraining set of metrology signals relate to measurements of a second set of targets, each of said second set of targets corresponding to one or more of said first set of targets or a subset thereof.

11. A method as claimed in any preceding claim, wherein said difference is determined for respective pairs of metrology signals, each pair comprising one metrology signal of said first constraining set of metrology signals and one metrology signal of said second constraining set of metrology signals.

12. A method as claimed in any preceding claim, wherein said training step trains the model to minimize a difference between values for the parameter of interest inferred using the model from the first set of metrology signals and their respective known reference values.

13. A computer program comprising processor readable instructions which, when run on suitable processor controlled apparatus, cause the processor controlled apparatus to perform the method of any of claims 1 to 12.

14. A processing apparatus comprising:

    a processor; and
    a computer program carrier comprising a computer program of claim 13.

15. A metrology apparatus comprising the processing apparatus of claim 14.

Fig. 1

Fig. 2

Fig. 3

Europäisches
Patentamt

European
Patent Office

Office européen
des brevets

# EUROPEAN SEARCH REPORT

**Application Number**

**EP 21 21 2240**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/121906 A1 (ASML NETHERLANDS BV [NL]) 24 June 2021 (2021-06-24) | 1-6,9, 10,13-15 | INV. G03F7/20 |
| Y | * paragraphs [0046] - [0056]; figure 1 * <br> * paragraphs [0251] - [0254] * <br> * paragraph [0273] * | 8 | G06N20/00 |
| X | US 2016/282105 A1 (PANDEV STILIAN IVANOV [US]) 29 September 2016 (2016-09-29) <br> * paragraphs [0008] - [0012] * <br> * paragraphs [0032] - [0039]; figure 1 * <br> * paragraphs [0076] - [0087]; figures 13,14 * | 1,6,7, 11,13-15 | |
| X | WO 2021/028126 A1 (ASML NETHERLANDS BV [NL]) 18 February 2021 (2021-02-18) <br> * paragraph [0074] * <br> * paragraph [0082] * <br> * paragraphs [0099] - [0115]; figure 7 * | 1,12-15 | |
| X | WO 2021/237019 A1 (VIEW INC [US]) 25 November 2021 (2021-11-25) <br> * paragraph [0002] * <br> * paragraphs [0063] - [0071]; figure 1 * <br> * paragraphs [0119] - [0127]; figure 15 * | 1,13-15 | TECHNICAL FIELDS SEARCHED (IPC) <br> G03F <br> G06N |
| Y | WO 2021/224009 A1 (ASML NETHERLANDS BV [NL]) 11 November 2021 (2021-11-11) <br> * paragraph [0078] * | 8 | |
| A | US 2021/116895 A1 (PAUL DAVID JOHN [US]) 22 April 2021 (2021-04-22) <br> * paragraphs [0084] - [0091]; figure 3 * | 1,13-15 | |

-/--

The present search report has been drawn up for all claims

| Place of search | Date of completion of the search | Examiner |
|---|---|---|
| Munich | 18 May 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | "LATENT SPACE SYNCHRONIZATION OF MACHINE LEARNING MODELS FOR IN-DEVICE METROLOGY INFERENCE", RESEARCH DISCLOSURE, KENNETH MASON PUBLICATIONS, HAMPSHIRE, UK, GB , vol. 692, no. 60 1 December 2021 (2021-12-01), XP007149852, ISSN: 0374-4353 Retrieved from the Internet: URL:ftp://ftppddoc/RDData692_EPO.zip Pdf/692060.pdf [retrieved on 2021-11-16] * paragraphs [0072] - [0101]; figures 7A,9B * ----- | 1,13-15 | |

**TECHNICAL FIELDS SEARCHED** (IPC)

The present search report has been drawn up for all claims

| Place of search | Date of completion of the search | Examiner |
|---|---|---|
| Munich | 18 May 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..............................................................................
& : member of the same patent family, corresponding document

EPO FORM 1503 03.82 (P04C01)

# EP 4 191 338 A1

## ANNEX TO THE EUROPEAN SEARCH REPORT
## ON EUROPEAN PATENT APPLICATION NO.

EP 21 21 2240

18-05-2022

| Patent document cited in search report | | Publication date | Patent family member(s) | | Publication date |
|---|---|---|---|---|---|
| WO 2021121906 | A1 | 24-06-2021 | TW | 202138927 A | 16-10-2021 |
| | | | WO | 2021121906 A1 | 24-06-2021 |
| US 2016282105 | A1 | 29-09-2016 | CN | 107408519 A | 28-11-2017 |
| | | | IL | 254330 A | 31-08-2021 |
| | | | KR | 20170129923 A | 27-11-2017 |
| | | | TW | 201703166 A | 16-01-2017 |
| | | | US | 2016282105 A1 | 29-09-2016 |
| | | | WO | 2016154352 A1 | 29-09-2016 |
| WO 2021028126 | A1 | 18-02-2021 | CN | 114222949 A | 22-03-2022 |
| | | | TW | 202111423 A | 16-03-2021 |
| | | | WO | 2021028126 A1 | 18-02-2021 |
| WO 2021237019 | A1 | 25-11-2021 | NONE | | |
| WO 2021224009 | A1 | 11-11-2021 | TW | 202147041 A | 16-12-2021 |
| | | | WO | 2021224009 A1 | 11-11-2021 |
| US 2021116895 | A1 | 22-04-2021 | NONE | | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 20100328655 A1
- US 2011069292 A1
- US 20110027704 A
- US 20110043791 A
- US 2011102753 A1
- US 20120044470 A
- US 20120123581 A
- US 20130258310 A
- US 20130271740 A
- WO 2013178422 A1
- WO 2017186483 A1
- US 20080239318 A
- US 20210255552 A